# EUROPEAN PATENT APPLICATION

(11) **EP 4 174 209 A1**
(43) Date of publication of application: **03.05.2023**
(21) Application number: 22203309.4
(22) Date of filing: 24.10.2022
(51) Int. Cl.: C23C 16/24, C23C 16/455, C23C 16/56, H01L 21/02

(54) **METHOD OF FORMING A DOPED POLYSILICON LAYER**

(30) Priority: 27.10.2021 US 202163272400 P
(71) Applicant: ASM IP Holding B.V., 1322 AP Almere (NL)
(72) Inventor: VAN AERDE, Steven R. A., 1322 AP Almere (NL); SU, Juan, 1322 AP Almere (NL)
(74) Representative: V.O.

(57) **Abstract**

A method and a wafer processing furnace for forming a doped polysilicon layer on a plurality of substrates is provided. In a preferred embodiment, the method comprises providing a plurality of substrates to a process chamber. It also comprises executing a deposition cycle comprising providing a silicon-containing precursor to the process chamber thereby depositing, on the plurality of substrates, an undoped silicon layer until a pre-determined thickness is reached and providing the process chamber with a flow of a dopant precursor gas without providing the silicon-containing precursor to the process chamber. The method also comprises performing a heat treatment process, thereby forming the doped polysilicon layer.

## Description

### Technical Field of the Disclosure

The present disclosure relates to the field of semiconductor processing. More specifically, it relates to a method of forming a doped polysilicon layer on a plurality of substrates and a wafer processing furnace configured to form the doped polysilicon layer.

### Background of the Disclosure

Polysilicon, commonly also known as polycrystalline silicon or poly-Si, is one of key materials used in the semiconductor industry in the fabrication of silicon devices. Heavily doped polysilicon has been widely used as a floating gate in NAND flash cells, as interconnection material in MOS circuits, as emitter for BJTs and as gate electrodes. Lightly doped polysilicon, on the other hand has been used in the fabrication of polysilicon diodes and as trench refill in dielectric isolation technologies.

In-situ doping is one of techniques used to obtain doped polysilicon, whereby the dopants are introduced into the polysilicon layer while the layer is being deposited. It involves the addition of the dopant gases to the reactant gases used in the polysilicon deposition.

In-situ doping of polysilicon is typically done by performing a Low Pressure Chemical Vapor Deposition (LPCVD) process. This allows for simplification on the fabrication as it requires no extra process for doping and no further process is needed for doping adjustment. However, introduction of the dopant gases during the growth of the layer may involve challenges associated with in-situ doping of polysilicon. These challenges may include control of the layer thickness, dopant uniformity, active dopant concentration and deposition rate. These challenges may become more pronounced in order to satisfy the demand towards obtaining higher deposition rates and highly doped, higher thickness polysilicon layers.

There is, therefore, a need in the art for providing improved methods of forming doped polysilicon layers.

### Summary of the Disclosure

It is an object of the present disclosure to provide improved methods of forming a doped polysilicon layer on a plurality of substrates. More specifically, certain embodiments may provide improved methods of forming thicker doped polysilicon layer on the plurality of substrates achieved at higher deposition temperatures and with increased growth rate. To at least partially achieve this goal, the present disclosure may provide a method and wafer processing furnace as defined in the independent claims. Further embodiments of the method and the wafer processing furnace are provided in the dependent claims.

In a first aspect, the present disclosure relates to a method of forming a doped polysilicon layer on a plurality of substrates. The method may comprise providing a plurality of substrates to a process chamber. It may also comprise executing a deposition cycle. This deposition cycle may comprise providing a silicon-containing precursor to the process chamber, thereby depositing on the plurality of substrates an undoped silicon layer until a pre-determined thickness is reached. The deposition cycle may also comprise providing the process chamber with a flow of a dopant precursor gas without providing the silicon-containing precursor to the process chamber. The method may also comprise performing a heat treatment process, thereby forming the doped polysilicon layer.

A method according to the first aspect may allow for forming a doped polysilicon layer on a plurality of substrates. This may have the advantage of providing improved throughput for the wafer processing.

Furthermore, it may allow forming the doped polysilicon layer with a higher thickness on the plurality of substrates thanks to enabling the deposition at a higher growth temperature. This may also have the advantage of improving the throughput of the process, thus making it commercially attractive.

It may further be an advantage of embodiments of the first aspect that it allows for obtaining a higher thickness doped polysilicon layer without sacrificing the uniformity of dopant concentration and/or dopant distribution throughout the layer.

It may be an advantage of embodiments of the first aspect that it allows for obtaining a higher doping concentration throughout the thickness of the doped polysilicon layer.

It may also be an advantage of embodiments of the first aspect that it provides achieving a uniform doping concentration throughout the thickness of the doped polysilicon layer.

It may further be an advantage of embodiments of the first aspect that it allows for providing improved wafer within uniformity for a highly doped thicker polysilicon layer.

It may also be an advantage of embodiments of the first aspect that it allows for forming a thicker polysilicon layer that can be doped with different dopants as well as having a higher and a uniform doping concentration throughout its thickness.

It may further be an advantage of embodiments of the first aspect that a dopant concentration in the polysilicon film, which may be lower than that obtained with in-situ doping, can be achieved, while also providing the advantage of improved wafer within non-uniformity.

In a second aspect, the present disclosure relates to a wafer processing furnace configured to form a doped polysilicon layer on a plurality of substrates according to embodiments of the first aspect of the present disclosure. The wafer processing furnace may comprise a process chamber extending in a longitudinal direction. It may also comprise a wafer boat for holding a plurality of substrates. The plurality of substrates may be longitudinally spaced apart. It may also comprise a silicon-containing precursor storage module, a dopant precursor storage module. The dopant precursor storage module may comprise a pnictogen hydride comprising dopant precursor gas or a boron-containing compound comprising dopant precursor gas. The wafer processing furnace may also comprise a gas providing manifold operationally connected to the silicon-containing precursor storage module and to the dopant precursor storage module. A gas injector may also be comprised in the wafer processing furnace, being operationally connected to the gas providing manifold and being arranged for injecting the silicon-containing precursor or the dopant precursor into the process chamber.

It may be an advantage of embodiments of the second aspect that it allows for simultaneously forming a doped polysilicon layer on a plurality of substrates, thereby improving throughput.

Furthermore, it may also be an advantage of embodiments of the second aspect that it allows for forming a doped polysilicon layer on a plurality of substrates at higher growth temperatures, thereby providing a higher deposition rate. This may further be advantageous since a higher deposition rate may allow for forming a thicker layer, thus making it commercially attractive.

It may be an advantage of embodiments of the second aspect that it allows for forming a highly doped polysilicon layer on a plurality of substrates.

Although there has been constant development in this field, the present concepts are believed to represent substantial new developments. Departures from prior art practices are included in the present concepts that result in improved methods and improved wafer processing furnaces.

The above and other characteristics, features and advantages of the present disclosure will become apparent from the following detailed description to be considered together with the drawings included. The drawings illustrate, by way of example, the principles of the disclosure. This description is given for the sake of example only, without limiting the scope of the disclosure. The reference figures referred to below relate to the drawings included.

Particular and preferred aspects of the disclosure are set out in the accompanying independent and dependent claims. Features from the dependent claims may be combined with features of the independent claims and with features of other dependent claims as appropriate and not as just set out in the claims.

### Brief Description of the Figures

The above, as well as additional objects, features and advantages of the present inventive concept, will be better understood through the following illustrative and non-limiting detailed description. Reference is also made to the drawings included. Like reference numbers will be used for like elements in the drawings unless stated otherwise.
Fig. 1: shows a flowchart of an exemplary method according to embodiments of the first aspect of the present disclosure.
Figs. 2a: shows a schematic cross-section of the plurality of undoped silicon layers and Fig. 2b shows a doped polysilicon layer according to embodiments of the first aspect of the present disclosure.
Fig. 3: shows change in Sheet Resistivity (mΩ-cm) and wafer within non-uniformity (WiW, %) based on sheet resistance (Rs) measured on different substrates.
Fig.4: shows a schematic representation of a wafer processing furnace according to embodiments of the second aspect of the present disclosure.

### Detailed Description of the Disclosure

The present disclosure will be described with respect to particular embodiments and with reference to certain drawings. However, the disclosure is not limited thereto but only by the claims. The dimensions and the relative dimensions do not correspond to actual reductions to practice the disclosure. The drawings described are only schematic and are non-limiting. The size of some of the elements may not be drawn to scale, in the drawings, for illustrative purposes.

It is to be noticed that the term "comprising", used in the claims, should not be interpreted as being restricted to the means listed thereafter. It does not exclude other elements or steps. It is thus, to be interpreted as specifying the presence of the stated features, integers, steps or components as referred to. However, it does not prevent one or more other steps, components, integers, or features, or groups thereof from being present or being added.

Reference throughout the specification to "embodiments" in various places throughout the specification are not necessarily all referring to the same embodiment, but may. Furthermore, the particular features, structures or characteristics maybe combined in any suitable manner, as would be apparent to one of the ordinary skill in the art from the disclosure, in one or more embodiments.

It should be understood that in the description of exemplary embodiments of the disclosure, various features of the disclosure are sometimes grouped together in a single embodiment, figure or description in order to help to understand one or more of the inventive aspects. The claims following the detailed description are incorporated into the detailed description, with each claim standing on its own as a separate embodiment of the disclosure.

Some embodiments described herein include some but not other features included in other embodiments. However, combinations of features of different embodiments are meant to be within the scope of the disclosure, and form different embodiments, as would be understood by those in the art. For example, in the following claims, any of the claimed embodiments can be used in any combination.

The following terms are provided solely to aid in the understanding of the disclosure.

As used herein and unless provided otherwise, the term *"highly doped*" refers to a layer having a dopant concentration of at least 5×10²⁰ atoms/cm³.

As used herein and unless provided otherwise, the term "wafer boat" refers to a device for holding a plurality of wafers.

As used herein and unless provided otherwise, the term "comprise substantially" refers that further components than those specifically mentioned can, but not necessarily have to, be present, namely those not materially affecting the essential characteristics of the material, compound, or composition referred to.

The disclosure will now be described by a detailed description of several embodiments of the disclosure. It is clear that other embodiments of the disclosure can be configured according to the knowledge of persons skilled in the art without departing from the technical teaching of the disclosure, the disclosure being limited only by the terms of the appended claims.

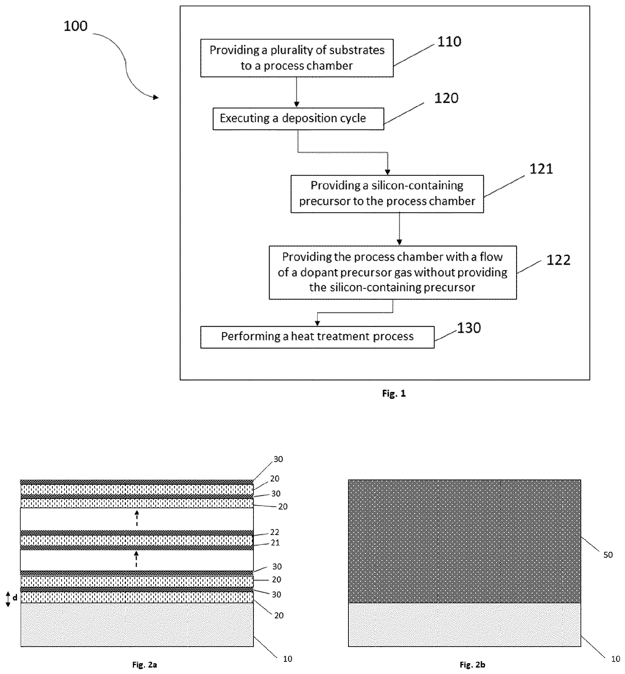

A flowchart of an exemplary method according to embodiments of the first aspect of the present disclosure is given in Fig. 1 and a schematic cross-section of the plurality of undoped silicon layers and a doped polysilicon layer according to embodiments of the first aspect of the present disclosure is given in Fig. 2a and Fig. 2b. respectively.

The method (100) may comprise providing (110) a plurality of substrates to a process chamber. In embodiments, this process chamber may be comprised in a wafer processing furnace. This wafer processing furnace may be a horizontal or a vertical wafer processing furnace. In embodiments, this wafer processing furnace may be a vertical wafer processing furnace. The plurality of substrates may, in embodiments, be arranged in a wafer boat and the wafer boat may thus, be loaded in the process chamber. In embodiments, the process chamber may be comprised in a Low Pressure Chemical Vapor Deposition (LPCVD) tool.

The provision of the plurality of substrates, on which the doped polysilicon (50) layer is to be formed, may have the advantage of increasing throughput as it allows for forming the doped polysilicon layer on a plurality of substrates in a single process run. This increase in throughput may further have an effect on increasing the overall throughput of the semiconductor manufacturing process. This may further be advantageous for reducing cost of wafer manufacturing, thereby providing economic wafer processing.

The plurality of substrates may, in embodiments, be semiconductor substrates (10). The semiconductor substrates may, in embodiments, be a Si (111) substrate or a Si(100) substrate. In embodiments, the plurality of substrates may comprise a semiconductor layer. This semiconductor layer may, in embodiments, be a Si (111) layer or a Si(100) layer. One or more surface layers may be formed on the substrate. Exemplary surface layers include oxides and nitrides such as silicon oxide and silicon nitride.

The method (100) may further comprise executing (120) a deposition cycle. This deposition cycle may comprise providing (121) a silicon-containing precursor to the process chamber, thereby depositing, on the plurality of substrates, an undoped silicon layer (20) until a pre-determined thickness (d) is reached. In embodiments, this undoped silicon layer (20) may be amorphous, microcrystalline, or polycrystalline. In some embodiments, the undoped silicon layer (20) may comprise one or more of amorphous silicon, microcrystalline silicon, and polycrystalline silicon.

The provision of this silicon-containing precursor to the process chamber may be done by the use of a gas injector. It is to be understood that this pre-determined thickness (d) may be controlled based on the growth rate of the undoped silicon layer by varying the different process parameters such as for example, flow rate, flow time and selection of the silicon-containing precursor, deposition temperature and pressure.

In embodiments, the execution of the deposition cycle may comprise purging at least one of the process chamber and the gas lines. They may be purged before, after, or before and after the provision of the silicon-containing precursor to the process chamber. Purging may be done at the same temperature as the provision of the silicon-containing precursor. Purging may be done in an inert atmosphere. In other words, a purge may comprise providing an inert gas to the reaction chamber. In some embodiments, the inert atmosphere may comprise substantially N₂. In some embodiments, the inert atmosphere may comprise substantially of one or more noble gasses such as He, Ne, Ar, Kr, and Xe; or the inert atmosphere may comprise substantially of at least one of N₂ and one or more noble gasses.

This deposition cycle may further comprise providing (122) the process chamber with a flow of a dopant precursor gas without providing the silicon-containing precursor to the process chamber. The provision of the flow of the dopant precursor gas may be done such that the provision of the silicon-containing precursor to the process chamber is stopped upon reaching the pre-determined thickness (d) of the undoped silicon layer (20) on the plurality of substrates. Thus, in some embodiments, there is no provision of the silicon-containing precursor to the process chamber while providing the dopant gas precursor to the process chamber. This may provide the advantage of subjecting the undoped silicon layer to the flow of the dopant precursor gas without causing the undoped silicon layer further to grow. This may have the advantage of not influencing the pre-determined thickness (d) during the provision of the flow of the dopant gas precursor. This may further indicate that, in some embodiments, the deposition rate of the silicon layer becomes independent of the provision of the dopant precursor gas.

In embodiments, the provision of the flow of the dopant precursor gas may be done in the presence of a carrier gas. The carrier gas may substantially comprise at least one of a noble gas, H₂, and N₂.

In embodiments, when the pnictogen hydride comprised in the dopant precursor gas comprise PH₃, it may be provided with a carrier gas comprising substantially H₂ at a concentration in the range of 1 v % to 5 v %., in which v % stands for volume percent.

In embodiments, the execution of the deposition cycle may further comprise purging at least one of the process chamber and one or more gas lines after provision of the dopant precursor gas. This may provide the advantage of clearing at least one of the process chamber and the one or more gas lines from the dopant precursor gas, thereby minimizing the risk for unintentional doping of the silicon layer during the provision of the silicon-containing precursor. Unintentional doping of the silicon layer may be due to a possible saturation of the process chamber with the precursor dopant gas that might have occurred during its provision.

The method (100) may further comprise performing a heat treatment process (130), thereby forming the doped polysilicon layer (50). The heat treatment process (130) may result in distributing the dopant in the silicon layer while forming the doped polysilicon layer (50). In embodiments, this heat treatment is to be done. Therefore, depending on the type of the dopant, the temperature of the heat treatment may need to be adjusted within this given range in order to be able to distribute the dopant uniformly within the silicon layer, throughout its thickness.

In embodiments, the execution of the deposition cycle (120) and the performance of the heat treatment (130) may be done in the same process chamber. This process chamber may then be a deposition chamber that can also perform a thermal treatment process. Alternatively, the execution of the deposition cycle (120) and the performance of the heat treatment (130) may be done in different process chambers. While the deposition cycle may then be executed in a deposition chamber, the performance of the heat treatment may be done in a chamber suitable for a thermal treatment process. While these different process chambers may be comprised in different wafer processing tools, they may also be comprised in the same wafer processing tool.

In embodiments, the execution of the deposition cycle (120) and the performance of the heat treatment (130) may be done in the same process chamber. This may have the advantage of avoiding contact with ambient air in between the execution of the deposition cycle and the performance of the heat treatment process while also avoiding unloading and loading of the wafer boat between different process chambers. This may, therefore, play a role on improving the throughput of the process. In embodiments, this process chamber, where both the execution of the deposition cycle (120) and the performance of the heat treatment (130) can be done, may be comprised in a LPCVD tool.

In embodiments, this provision (122) of the flow of the dopant precursor gas may be performed in such a way as to at least partially saturate the surface of the undoped silicon layer with the dopant precursor. Saturating the surface of the undoped silicon layer may help to create a concentration gradient. This may be advantageous since it may contribute to incorporating as much dopant as possible throughout the pre-determined thickness (d) upon performing the heat treatment process (130). In embodiments, this pre-determined thickness (d) may be selected such that, upon performing the heat treatment process (130), it allows for incorporating the dopant from the at least partially saturated surface through the undoped silicon layer thickness, so that a uniform dopant distribution throughout the pre-determined thickness (d) can be obtained.

Several approaches may be executed in terms of determining the saturation of the surface of the undoped silicon layer (20) with the dopant. A first approach may be to execute the deposition cycle (120) once and thereafter, provide the silicon-containing precursor a second time. Performing, for example, a Secondary-Ion Mass Spectrometry (SIMS) analysis on the substrate after provision of the silicon-containing precursor the second time could provide the information on the surface saturation of the surface of the undoped silicon layer (20) with the dopant.

An alternative approach may be performing the heat treatment process (130) after the provision of the silicon-containing precursor the second time in the first approach. This may then be followed by measuring the sheet resistance (Rs) across the substrate surface and monitoring, thereafter, the wafer within non-uniformity. A correlation of the SIMS data obtained from the first approach with the Rs values obtained from the second approach may help to provide a calibration curve, thereby helping to identify the surface saturation with the dopant.

It is to be understood that the selection of the pre-determined thickness (d) may require, that at least the dopant type and the temperature, at which the heat treatment process is to be performed, may need to be considered in order to have a uniform dopant distribution throughout the pre-determined thickness (d) after performing the heat treatment process (130). It may be difficult for a dopant, which has a lower diffusion coefficient in silicon at a given heat treatment temperature to diffuse throughout the pre-determined thickness (d) if the pre-determined thickness is not tuned properly. In embodiments, the pre-determined thickness (d) may thus, be from at least 5 nm to at most 500 nm, or from at least 5 nm to at most 10 nm, or from at least 10 nm to at most 20 nm, or from at least 20 nm to at most 50 nm, or from at least 50 nm to at most 100 nm, or from at least 100 nm to at most 200 nm, or from at least 200 nm to at most 500 nm.

The duration and the temperature of the provision of the flow of the dopant precursor gas may play a role on how far the dopant can diffuse from the surface already during the provision of the flow of the dopant precursor. Therefore, it is to be understood that these parameters may play an important role on saturating the surface of the undoped silicon layer while minimizing diffusion far from the surface and into the undoped silicon layer. In embodiments, the provision of the flow of the dopant precursor gas may be performed from at least 30 seconds to at most 10 minutes, or from at least 30 seconds to at most 1 minute, or from at least 1 minute to at most 2 minutes, or from at least 2 minutes to at most 5 minutes, or from at least 5 minutes to at most 10 minutes. Thus, the surface of the undoped silicon layer can be suitably saturated with dopant precursor.

In embodiments, the deposition cycle may be executed a plurality of times before performing the heat treatment process (130). This leads to undoped silicon layers (20) to be deposited incrementally, whereby each layer (20) has an upper surface (22) and a lower surface (21) being saturated as a result of the flow of the dopant precursor gas. In other words, the dopant saturated surfaces of the undoped silicon layers are sandwiched between the undoped silicon layers (20). This may provide the advantage that dopant evaporation during the performance of the heat treatment (130) is avoided. This may then lead to better-controlled diffusion through the undoped silicon layers (20) upon performing the heat treatment (130).

In embodiments, this incremental deposition of the undoped silicon layer may be such that the pre-determined thickness (d) is the same after execution of the deposition cycle plurality of times. In other words, a method as described herein may comprise repeating the following sequence several times: forming an undoped silicon layer having a pre-determined thickness and saturating the surface of the undoped silicon layer with dopant precursor. This may provide the advantage of providing a thicker doped polysilicon layer (50) upon performing the heat treatment process (130). Furthermore, since the undoped silicon layers (20), having the pre-determined thickness (d), are deposited incrementally in between the provision of the flow of the dopant precursor gas, the possibility of having hindrance to dopant diffusion or dopant non-uniformity in terms dopant concentration and/or distribution across the thickness of the doped polysilicon layer (50) obtained after performing the heat treatment process (130) may be reduced. In other words, alternatingly forming undoped silicon and exposing the substrates to dopant precursor gas can advantageously improve both dopant concentration uniformity and dopant distribution throughout a doped polysilicon layer formed using a method as described herein.

In some embodiments, this incremental deposition of the undoped silicon layer may be such that the pre-determined thickness (d) increases as the deposition cycle is executed a plurality of times. This increase in the pre-determined thickness (d) may be a gradual increase. In other words, a method as described herein can comprise a super cycle, a super cycle comprising forming an undoped silicon layer and exposing the substrates to dopant precursor gas, wherein subsequent super cycles comprise forming undoped silicon layers having a changing, for example, increasing, thickness. This may provide the advantage of achieving a concentration gradient of the dopant throughout the thickness of the doped polysilicon layer (50) obtained after performing the heat treatment process.

It may be a further advantage of embodiments of the first aspect that a dopant concentration in the polysilicon film (50), which may be lower than that obtained with in-situ doping, can be achieved, while also providing the advantage of improved wafer within non-uniformity. Typically, the lowest achieved dopant concentrations with in-situ doping of polysilicon layers is around 5×10¹⁹ at/cm³. Even though approaches may exist that provides dopant concentrations lower than 5×10¹⁹ at/cm³, they may run the risk of compromising from wafer within non-uniformity.

In embodiments, the doped polysilicon layer may have a uniform dopant concentration. This may be thanks to the heat treatments process (130) that the distribution of the dopant becomes uniform throughout the thickness of the doped polysilicon layer (50). In embodiments, where the deposition cycle (120) is executed a plurality of times, the heat treatment process (130) may also lead to the uniform dopant concentration in each of the silicon layers (20) having the pre-determined thickness (d), thereby leading to overall uniform dopant concentration in the doped polysilicon layer (50).

In embodiments, the doped silicon layer (50) may have a dopant concentration of at least 1×10¹⁸at/cm⁻³. Dopant concentrations (at/cm³) can be measured by Secondary Ion Mass Spectroscopy (SIMS).

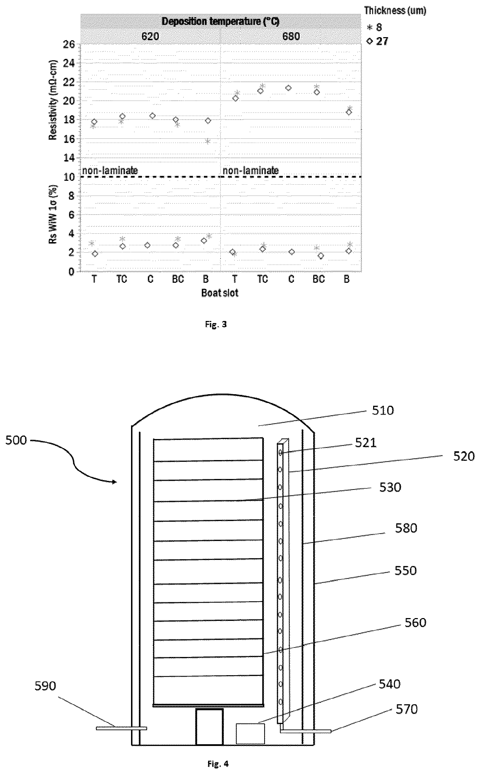

The uniform dopant distribution may also have an improved advantage on sheet resistivity and wafer within uniformity of the sheet resistance. Fig. 3 shows the change in Sheet resistivity (mΩ-cm) and wafer within non-uniformity (WiW, %) based on sheet resistance (Rs) measured on substrates that were processed in accordance with embodiments of the first aspect of the present disclosure. Two different deposition cycle temperatures are used: 620 ⁰C and 680 ⁰C. The thickness of the doped polysilicon layer (50) is 8 nm and 27 nm. The heat treatment is performed at 900 ⁰C. The pnictogen hydride comprised in the dopant precursor gas is PH₃. The horizontal axis shows the placement of the substrates within the wafer boat with T, TC, C, BC and B representing top, top-center, center, bottom-center and bottom, respectively. It is to be noted that both the provision (121) of the silicon-containing precursor and provision (122) of the flow of the dopant precursor gas is performed at these two different temperatures. The dotted horizontal line indicates the wafer within non-uniformity based on sheet resistance when provision of the dopant precursor gas is performed in-situ. It is observed that substrates processed according to embodiments of the first aspect of the present disclosure indicate wafer within non-uniformity based on sheet resistance values falling below 4%. Wafer within non-uniformity based on sheet resistance being scattered around 3% may be an indication of uniform doping concentration obtained across the substrate. This may further indicate the uniform doping concentration achieved through out the thickness of the doped polysilicon layer across the substrate.

In embodiments, the dopant precursor gas may comprise a pnictogen hydride, having a general formula of XH₃, X being a pnictogen. In embodiments, the pnictogen hydride may comprise at least one of PH₃ and AsH₃. Their suitability and availability for use when processing a plurality of substrates and their ability to tune the conductivity of silicon layer may provide the advantage for their use. Furthermore, it may be an advantage of embodiments of the present disclosure that the possibility of having hindrance to diffusion or dopant non-uniformity in terms of dopant concentration and/or dopant distribution across the thickness of the doped polysilicon layer (50) obtained after performing the heat treatment process (130) may particularly be reduced when the dopant precursor gas comprises PH₃.

In embodiments, the dopant precursor gas may comprise a Group IIIA-containing compound. In embodiments, this Group IIIA-containing compound may be a boron-containing compound. In embodiments, this boron-containing compound may comprise a borane, having a general formula of B_{X}H_{Y}, wherein x and y are integers. In some embodiments, x is from at least 1 to at most 12. Suitable boranes include BH₃ and B₂H₆.

In embodiments, this boron-containing compound may also comprise a boron halide. In embodiments, this boron halide may be a boron trihalide, having a general formula of BX₃, wherein X is a halogen. In embodiments, this boron trihalide may be BCl₃. Therefore, in embodiments, the boron-containing compound may comprise BCl₃ or B₂H₆.

In embodiments, the provision of the dopant precursor gas and the provision of the silicon-containing precursor may be performed at a temperature of at least 350 ⁰C to at most 700 ⁰C, or at a temperature of at least 350 ⁰C to at most 500 ⁰C, or a temperature of at least 500⁰C to at most 700 ⁰C. This temperature range may be advantageous since it opens up the route to the possibility of using different silicon-containing precursors. While some of the silicon-containing precursors can be applied at higher temperature ranges within this given range, some others may be applied on the lower side of this temperature range to benefit from lower temperature deposition of the undoped silicon layer. In embodiments, the provision of the dopant precursor gas and the provision of the silicon-containing precursor may be performed at the same temperature. In embodiments, this same temperature falls within the temperature range of 350 ⁰C to 700 °C. This may be advantageous since it allows for avoiding temperature ramp-up and temperature ramp-down while executing the deposition cycle. This may be particularly advantageous when the deposition cycle is executed a plurality of times since avoiding a plurality of temperature ramp-ups and temperature ramp-downs may contribute to improving throughput of the process. Indeed, process time may be decreased by avoiding a plurality of temperature ramp-ups and temperature ramp-downs. Furthermore, a plurality of temperature ramp-ups and temperature ramp-downs may lead to stress build up in the undoped silicon layers as the cumulative thickness is increased. This may, in turn, lead to processing issues regarding further wafer processing to be performed. Therefore, by performing the provision of the dopant precursor gas and the provision of the silicon-containing precursor at the same temperature, such problems may be alleviated.

In embodiments, this silicon-containing precursor may be selected from a silane. This silane may, in embodiments, be a monosilane, a disilane or a trisilane. These silane precursors may have the advantage of being provided at different temperature ranges such that deposition of the undoped silicon layer (20) can be carried out at different temperature ranges.

In embodiments, the provision of the dopant precursor gas and the provision of the silicon-containing precursor may be performed at a temperature in the range of 500 ⁰C to 700 °C. In such embodiments, the silicon-containing precursor may comprise, or may comprise substantially, monosilane. The provision of the silicon-containing precursor in this high temperature range may provide the advantage of having increased deposition rate. For high volume manufacturing involving batch processes, this may provide the advantage of improving cycle time.

In embodiments, the provision of the dopant precursor and the provision of the silicon-containing precursor may be performed at a temperature in the range of 350 °C to 500 ⁰C. In such embodiments, the silicon-containing precursor may comprise, or may comprise substantially, at least one of disilane and trisilane. Use of disilane or trisilane may allow for executing the deposition cycle at a lower temperature.

Executing the deposition cycle at a lower temperature using disilane or trisilane may be advantageous in terms of thermal budget of the process. This may reflect itself in improving the manufacturing cost.

Furthermore, it may provide the advantage that the surface of the undoped silicon layer (20) has a minimal topography in the nanometer, sub-nanometer or angstrom scale. In other words, a method as described herein may advantageously provide smooth undoped silicon layers. This may be advantageous in reducing the risk for creating topography issues in the doped polysilicon layer (50) after performing the heat treatment (130). Topography issues may pose challenges in the execution of consecutive process steps. Besides, unless handled properly, topography issues may lead to decrease in yield and decrease in device reliability. Additionally, executing the deposition cycle at a lower temperature using disilane or trisilane may be advantageous in providing undoped silicon layers (20), where layer closure can be achieved at lower thicknesses, such as for example, at 2 to 3 nm, compared to those obtained when executing the deposition cycle at a higher temperature such as with the use of silane. This may further be advantageous in applications in need of the provision of doped polysilicon layers (50) at lower thicknesses with improved dopant distribution and dopant concentration throughout its thickness.

A combination of a silicon-containing precursor comprising substantially disilane or trisilane and a dopant precursor gas in accordance with the embodiments of the method described herein may also provide the advantage of obtaining a highly doped polysilicon layer. This may be due to the possibility of forming the incremental undoped silicon layers thanks to the early closure of the layer obtained at a lower pre-determined thickness.

In embodiments, the provision of the silicon-containing precursor may be done at a pressure of at least 50 mTorr to at most 500 mTorr or at a pressure of at least 50 mTorr to at most 150 mTorr or at a pressure of at least 150 mTorr to at most 250 mTorr, or at a pressure of at least 250 mTorr to at most 350 mTorr or at a pressure of at least 350 mTorr to at most 500 mTorr. This may provide the advantage of obtaining improved sheet resistance wafer within non-uniformity. Furthermore, this may provide the advantage of decreasing the depletion of silicon-containing precursor. This may be advantageous when forming the doped polysilicon in a batch furnace, where plurality of substrates are arranged in a wafer boat that are loaded in the process chamber. This may, particularly, be advantageous when using, for example, silane as the silicon-containing precursor.

In a second aspect, the present disclosure relates to a wafer processing furnace (500) (Fig. 4)) configured to form a doped polysilicon layer on a plurality of substrates according to embodiments of the first aspect of the present disclosure.

The wafer processing furnace (500) may comprise a process chamber (510) extending in a longitudinal direction. It may have an outer enclosure (550). It may also comprise a wafer boat (560) for holding a plurality of substrates (530). This may be an advantage that doped polysilicon layer can be formed on the plurality of substrates (530), thereby improving throughput.

The plurality of substrates (530) may, in embodiments, be semiconductor substrates (10). The semiconductor substrates may, in embodiments, be a Si (111) substrate or a Si(100) substrate. In embodiments, the plurality of substrates may comprise a semiconductor layer. This semiconductor layer may, in embodiments, be a Si (111) layer or a Si(100) layer. The plurality of substrates may be longitudinally spaced apart.

The wafer processing furnace (500) may also comprise a silicon-containing precursor storage module and a dopant precursor storage module (not shown in the figure). The silicon-containing storage module may, in embodiments, comprise a silane precursor. The silane precursor may in embodiments be a monosilane or a higher order silane. The higher order silane may be a dislane or a trisilane. In embodiments, the silicon-containing storage module may comprise a halosilane precursor having a general formula of SiHₙX₄₋ₙ, wherein X is a halogen being Cl, Br and wherein n is 0,1 or 2.

The wafer processing furnace (500) may, in embodiments, comprise a controller (540). The controller (540) may be configured for causing the wafer processing furnace (500) to execute a method as described herein. The wafer processing furnace (500) may, in embodiments, further comprise a heater (not shown in the figures) configured for heating the process chamber (510).

The dopant precursor storage module may comprise a pnictogen hydride comprising dopant precursor gas or a boron-containing compound comprising dopant precursor gas. The pnictogen hydride having a general formula of XH₃, X being a pnictogen. In embodiments, the pnictogen hydride may comprise at least one of PH₃ and AsH₃.

In embodiments, the dopant precursor storage module (not shown in the figure) may comprise a Group IIIA-containing compound comprising precursor gas. In embodiments, this Group IIIA-containing compound may be a boron-containing compound. In embodiments, this boron-containing compound may comprise a borane, having a general formula of BxHy, wherein x and y are integers. In some embodiments, x is from at least 1 to at most 12. Suitable boranes may include BH₃ and B₂H₆.

In embodiments, this boron-containing compound may comprise a boron halide. In embodiments, this boron halide may be a boron trihalide, having a general formula of BX₃, wherein X is a halogen. In embodiments, this boron trihalide may be BCl₃.

The wafer processing furnace (500) may also comprise a gas providing manifold (not shown in the figure) operationally connected to the silicon-containing precursor storage module and to the dopant precursor storage module. A gas injector (520) may also be comprised in the wafer processing furnace (500), being operationally connected to the gas providing manifold and being arranged for injecting the silicon-containing precursor or the dopant precursor gas into the process chamber. The silicon-containing precursor or the dopant precursor gas may be provided to the gas injector (520) via a gas inlet (570). The gas injector may have plurality of gas injection holes (521) in order to introduce the silicon-containing precursor or the dopant precursor gas into the process chamber (510).

The wafer processing furnace (500) may comprise a liner. This liner may, in embodiments, be an open liner (580) (Fig. 4). In some embodiments, the liner may be a closed liner (not shown in the figure). In embodiments, where the liner is a closed liner, a different gas injector may be used for introducing the silicon-containing precursor or the dopant precursor gas into the process chamber (510).

The wafer processing furnace (500) may also comprise a gas outlet (590), configured for letting an exhaust gas out of the process chamber (510), after processing is completed in the process chamber (510).

This wafer processing furnace (500) may be advantageous as it allows for forming a doped polysilicon layer on the plurality of substrates (530) at higher growth temperatures, thereby providing a higher deposition rate. This may further be advantageous since a higher deposition rate may allow for forming a thicker layer in a shorter period of time while providing improved throughput, thus making it commercially attractive. Furthermore, this wafer processing furnace (500) may further be advantageous as it allows for forming a highly doped polysilicon layer on a plurality of substrates.

In embodiments, this wafer processing furnace may be a horizontal or a vertical furnace.

In embodiments, the wafer processing furnace (500) may be a vertical furnace and the process chamber may extend in a vertical direction. The plurality of substrates (530) may, in embodiments, be arranged in a wafer boat (560) thus, vertically spaced apart from one another. The wafer boat (560) may, be loaded in the process chamber (510) of this vertical furnace (500).

In embodiments, the wafer processing furnace (500) may be a Low Pressure Chemical Vapor Deposition (LPCVD) tool.

## Claims

1. A method of forming a doped polysilicon layer on a plurality of substrates, the method comprising:
- providing a plurality of substrates to a process chamber,
- executing a deposition cycle, comprising:
• providing a silicon-containing precursor to the process chamber, thereby depositing, on the plurality of substrates, an undoped silicon layer until a pre-determined thickness is reached,
• providing the process chamber with a flow of a dopant precursor gas without providing the silicon-containing precursor to the process chamber,
- performing a heat treatment process, thereby forming the doped polysilicon layer.

2. The method according to claim 1, wherein the provision of the flow of the dopant precursor gas is performed in such a way as to at least partially saturate the surface of the undoped silicon layer with the dopant precursor.

3. The method according to claim 1 or 2, wherein the deposition cycle is executed a plurality of times before performing the heat treatment.

4. The method according to any one of claims 1 to 3, wherein the doped polysilicon layer has a dopant concentration of at least 1×10¹⁸at/cm⁻³.

5. The method according to any one of claims 1 to 4, wherein the pre-determined thickness is in the range of 5 nm to 500 nm.

6. The method according to any one of claims 1 to 5, wherein the dopant precursor gas comprises a pnictogen hydride or a boron-containing compound.

7. The method according to any one of claims 1 to 6, wherein the provision of the flow of the dopant precursor gas is performed from 30 seconds to 10 minutes.

8. The method according to any one of claims 1 to 7, wherein the provision of the dopant precursor gas and the provision of the silicon-containing precursor is performed at a temperature in the range of 350 ⁰C to 700 ⁰C.

9. The method according to any one of claims 1 to 8, wherein the silicon-containing precursor is selected from a silane.

10. The method according to claim 9, wherein the provision of the dopant precursor and the provision of the silicon-containing precursor is performed at a temperature in the range of 500 ⁰C to 700 ⁰C and wherein the silicon-containing precursor comprises substantially monosilane.

11. The method according to claim 9, wherein the provision of the dopant precursor and the provision of the silicon-containing precursor is performed at a temperature in the range of 350 ⁰C to 500 ⁰C and wherein the silicon-containing precursor comprises substantially at least one of disilane and trisilane.

12. The method according to any one of claims 1 to 11, wherein the provision of the dopant precursor gas and the provision of the silicon-containing precursor is performed at the same temperature.

13. The method according to any one of claims 1 to 12, wherein the provision of the silicon containing precursor is done at a pressure in the range of 50 mTorr to 500 mTorr.

14. The method according to any one of claims 1 to 13, wherein the heat treatment is performed at a temperature in the range of 900 ⁰C to 1100 ⁰C.

15. A wafer processing furnace configured to form a doped polysilicon layer on a plurality of substrates according to any one of claims 1 to 14, the wafer processing furnace comprising:
- a process chamber extending in a longitudinal direction,
- a wafer boat for holding a plurality of substrates, wherein the plurality of substrates are longitudinally spaced apart,
- a silicon-containing precursor storage module,
- a dopant precursor storage module comprising a pnictogen hydride comprising dopant precursor gas or a boron-containing compound comprising dopant precursor gas,
- a gas providing manifold operationally connected to the silicon-containing precursor storage module and to the dopant precursor storage module,
- a gas injector being operationally connected to the gas providing manifold and being arranged for injecting the silicon-containing precursor or the dopant precursor into the process chamber.

16. The wafer processing furnace according to claim 15, further comprising a controller configured for causing the wafer processing furnace to execute a method according to any one of claims 1 to 14.

17. The wafer processing furnace according to claim 15 or 16, being a vertical furnace and wherein the process chamber extends in a vertical direction.
